# EUROPEAN PATENT APPLICATION

(11) **EP 3 889 100 A1**
(43) Date of publication of application: **06.10.2021**
(21) Application number: 19890889.9
(22) Date of filing: 14.11.2019
(51) Int. Cl.: B81B 3/00, G02B 26/08, G02B 26/10

(54) **DRIVING DEVICE**

(30) Priority: 30.11.2018 JP 2018225145
(71) Applicant: Pioneer Corporation, Tokyo 113-0021 (JP)
(72) Inventor: KITAZAWA, Shogo, Tokyo 113-0021 (JP)
(74) Representative: Grünecker Patent- und Rechtsanwälte PartG mbB
(86) International application number: PCT/JP2019/044654
(87) International publication number: WO 2020/110746

(57) **Abstract**

A driving device capable of downsizing the entire device is provided. A mirror (2) is rotatably supported by a rotary frame (3) via an inner torsion bar (20), and the rotary frame (3) is rotatably supported by a base part (4) via an outer torsion bar (30). Magnetic elements (5A, 5B) are provided on the rotary frame (3), thus the mirror (2) and ends (74, 75) of yoke parts (7A, 7B) are prevented from interfering with each other, and, by disposing the magnetic elements (5A, 5B) and the ends (74, 75) close to each other, the entire device can be downsized.

## Description

### TECHNICAL FIELD

The present invention relates to a driving device.

### BACKGROUND ART

Conventionally, there has been proposed a magnetic force type driving device configured to rotate a movable plate by rotatably supporting the movable plate with respect to a frame with a pair of beams and by providing an end of a yoke in the vicinity of a permanent magnet fixed on a back side of the movable plate (refer for example to Patent Document 1). In the magnetic force type driving device described in Patent Document 1, a coil that generates magnetic poles at the ends of the yoke when applied with current is wound around the yoke at a position spaced apart from the movable plate in a plate thickness direction.

### CITATION LIST

### Patent Document

Patent Document 1: JP 2012-208395 A

### SUMMARY OF THE INVENTION

### Problem to be Solved

In the driving device described in Patent Document 1, since the coil is wound around the yoke at the position sufficiently separated from the movable plate in the plate thickness direction so as to prevent interference when the movable plate is rotated, there was a drawback that the size of the entire device is likely to increase in the plate thickness direction.

Therefore, an example of the problem to be solved by the present invention is to provide a driving device that can downsize the entire device.

### Solution to Problem

In order to solve the problem and to achieve the object described above, a driving device of the present invention according to claim 1 includes a first driven part, a second driven part that rotatably supports the first driven part via a first shaft part, a base part that rotatably supports the second driven part via a second shaft part, a magnetic element provided on the second driven part, and a yoke part that includes a pair of ends and that is configured to rotate the first driven part via the second driven part by applying, to the magnetic element, a magnetic field generated at the ends, wherein the yoke part is arranged to sandwich, between the pair of ends, a reference plane on which the base part extends. Further, a driving device of the present invention according to claim 11 includes a movable part, a base part that rotatably supports the movable part via a shaft part, a magnetic element provided on the movable part, and a driving section that includes a coil part and that is configured to rotate the movable part by applying, to the magnetic element, a magnetic field generated by the coil part, wherein the coil part is formed by a wiring extending along the base part.

### BRIEF DESCRIPTION OF THE DRAWINGS

FIG. 1 is a perspective view showing a driving device according to a first example of the present invention;
FIG. 2 is a perspective view showing an upper face side of the driving device;
FIG. 3 is a perspective view showing a lower face side of the driving device;
FIG. 4 is a perspective view showing a yoke part and a magnetic element of the driving device;
FIG. 5 is a perspective view showing a driving device according to a second example of the present invention;
FIG. 6 is a perspective view showing a lower face side of the driving device;
FIG. 7 is a perspective view showing a main part of the driving device;
FIG. 8 is a perspective view showing a driving device according to a third example of the present invention; and
FIG. 9 is a perspective view showing a lower face side of the driving device.

### DESCRIPTION OF EMBODIMENTS

An embodiment of the present invention will be described below. A driving device according to an embodiment of the present invention includes a first driven part, a second driven part that rotatably supports the first driven part via a first shaft part, a base part that rotatably supports the second driven part via a second shaft part, a magnetic element provided on the second driven part, and a yoke part including a pair of ends and configured to rotate the first driven part via the second driven part by applying the magnetic field generated at these ends to the magnetic element. The yoke part is configured such that the pair of ends thereof sandwiches a reference plane on which the base part extends.

Since the magnetic element is provided on the second driven part, the first driven part and the ends of the yoke part are prevented from interfering with each other, and, by disposing the magnetic element close to the ends of the yoke part, the entire device can be downsized. Further, the first driven part and the ends of the yoke part are prevented from interfering with each other even when the driving force is increased by disposing the magnetic element close to the ends of the yoke part and the swing angle of the first driven part is increased. In this instance, when a magnetic field having a frequency corresponding to the resonance frequency of the first driven part is generated at the ends of the yoke part, the swing angle of the first driven part can be increased while the swing angle of the second driven part can be reduced, thereby preventing the interference between the second driven part and the ends of the yoke part. In this way, it is possible to prevent the interference between the components while obtaining a large driving force, and the swing angle of the first driven part can be increased.

The magnetic element and the ends of the yoke part are arranged at positions corresponding to each other in the axis direction of the first shaft part (or the second shaft part). In order to obtain a large driving force, it is preferable that their positions in the axis direction correspond to each other; however, for convenience of arrangement of other components, for example, they may be positioned slightly displaced from each other in the axis direction.

It is preferable that the magnetic element is disposed on a closest part on the second driven part closest to the base part. This facilitates application of the magnetic field generated at the ends of the yoke part onto the magnetic element, thereby obtaining a large driving force.

It is preferable that the magnetic element is arranged at the central part of the second driven part in the axis direction of the second shaft part. This can prevent a movement such as twisting with respect to the rotation around the second shaft part as the axis direction during the driving of the second driven part.

The first driven part is formed in a circular plate shape or an elliptical plate shape, and the magnetic element is arranged on the second driven part at a position displaced in the axis direction of the first shaft part with respect to the closest part where the base part is closest to the first driven part. Consequently, the first driven part can be easily disposed close to the base part at the closest part, and the surface area of the first driven part can be increased.

Further, at a position corresponding to the closest part, the second driven part has a width in a facing direction in which the base part and the first driven part face each other that is smaller than that of rest of the second driven part. Consequently, in a case where the first driven part is a mirror, it is possible to prevent the light from being blocked by the second driven part at the closest part.

It is preferable that the magnetic elements are arranged on both sides of the second driven part in the intersecting direction intersecting the axis direction of the second shaft part. Consequently, a driving force can be applied to the second driven part from both sides in the intersecting direction.

It is preferable that the driving device further includes a coil part, and the wiring part forming the coil part includes an axially extending part that extends along the base part and extends in the axis direction of the second shaft part, and the yoke part is formed in an opened annular shape that surrounds the axially extending part from both sides of the reference plane and from a side opposite to the second driven part and that is opened on the second driven part side. Consequently, when a current flows through the axially extending part, the lines of magnetic force concentrate at the yoke part, and this can facilitate application of the magnetic field onto the magnetic element on the second driven part side where it is opened.

It is preferable that the first shaft part and the second shaft part are arranged coaxially. Consequently, the driving force applied to the second driven part can be easily transmitted to the first driven part.

It is preferable that the driving device further includes a coil part and a pedestal which is made of a non-magnetic material and to which the base part is joined, and that the coil part is disposed on the pedestal or in the pedestal. Consequently, by disposing the coil part on the pedestal or in the pedestal, the entire driving device can be downsized.

The driving device according to another embodiment of the present invention includes a driving device including a movable part, a base part that rotatably supports the movable part via a shaft part, a magnetic element provided on the movable part, and a driving section that includes a coil part and that is configured to rotate the movable part by applying, to the magnetic element, a magnetic field generated by the coil part. The coil part is formed by a wiring extending along the base part.

Since the coil part is constituted of the wiring that extends along the base part, the entire driving device can be downsized as compared with the configuration in which the coil part is arranged side by side with respect to the base part.

### EXAMPLES

Each example of the present invention will be described in detail below. With respect to a second example and a third example, the same components and the components having the same function as those described in a first example are designated by the same reference signs as those in the first example, and the description thereof is omitted.

### FIRST EXAMPLE

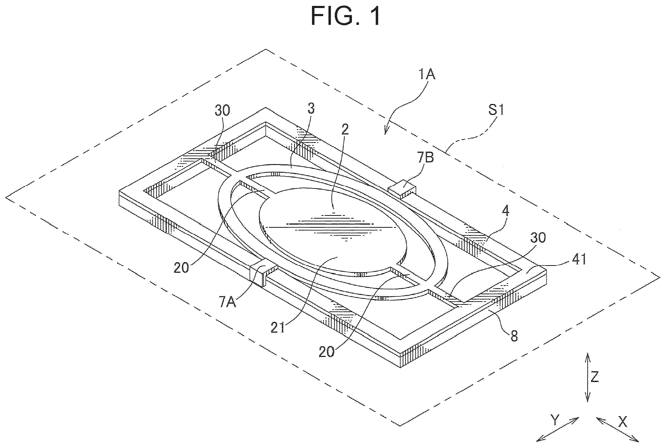

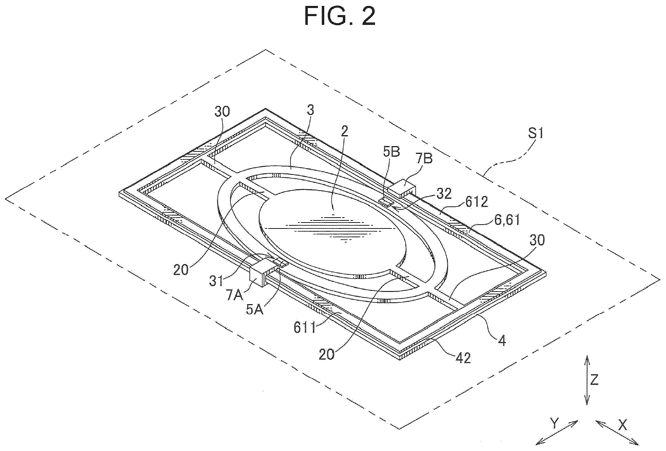

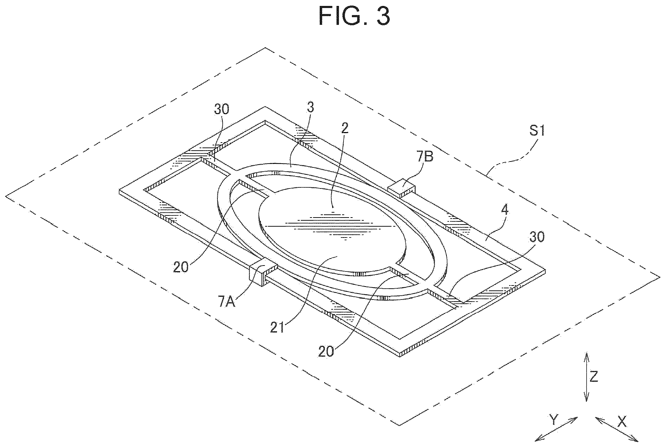

As shown in FIGS. 1 to 3, a driving device 1A of this example is an optical deflector including a mirror 2 as a first driven part, a rotary frame 3 as a second driven part, a base part 4, two magnetic elements 5A, 5B, a coil part 6, two yoke parts 7A, 7B, a pedestal 8, an inner torsion bar 20 as a first shaft part, and an outer torsion bar 30 as a second shaft part. The driving device 1A is used, for example, for a detection device that is mounted on a vehicle to detect a distance from another vehicle, an installation or the like by transmitting and receiving light such as infrared rays.

In this example, the inner torsion bar 20 and the outer torsion bar 30 are arranged coaxially, wherein an extending direction (axis direction) thereof corresponds to an X direction, and a plate thickness direction of the mirror 2 corresponds to a Z direction. A direction orthogonal to both the X direction and the Z direction is a Y direction, that is, the mirror 2 extends along the XY plane.

The mirror 2 is formed in an elliptical plate shape with its longitudinal direction corresponding to the X direction, and a surface 21 thereof is a reflective face formed by mirror finishing. The inner torsion bars 20 are connected to both ends of the mirror 2 in the X direction.

The rotary frame 3 is formed in an elliptical annular shape when viewed from the Z direction with its longitudinal direction corresponding to the X direction, and it extends along the XY plane so as to surround the mirror 2. The both ends of the rotary frame 3 in the X direction are provided with the inner torsion bars 20 connected to inner sides of said both ends and the outer torsion bars 30 connected to outer sides of said both ends. That is, the mirror 2 is rotatably supported by the rotary frame 3 via the inner torsion bars 20.

The base part 4 is formed in a rectangular frame shape when viewed from the Z direction with its longitudinal direction corresponding to the X direction, and it extends along the XY plane so as to surround the rotary frame 3. The outer torsion bars 30 are connected to an inner side of the base part 4 on both ends in the X direction and on central parts in the Y direction. That is, the rotary frame 3 is rotatably supported by the base part 4 via the outer torsion bars 30. Herein, a plane on which the base part 4 extends is defined as a reference plane S1. The reference plane S1 is arranged along the XY plane, and the mirror 2 and the rotary frame 3 also extend along the reference plane S1.

The mirror 2, the rotary frame 3 and the inner torsion bars 20 as described above constitute a movable part, and the movable part is rotatably supported by the base part 4 via the outer torsion bars 30.

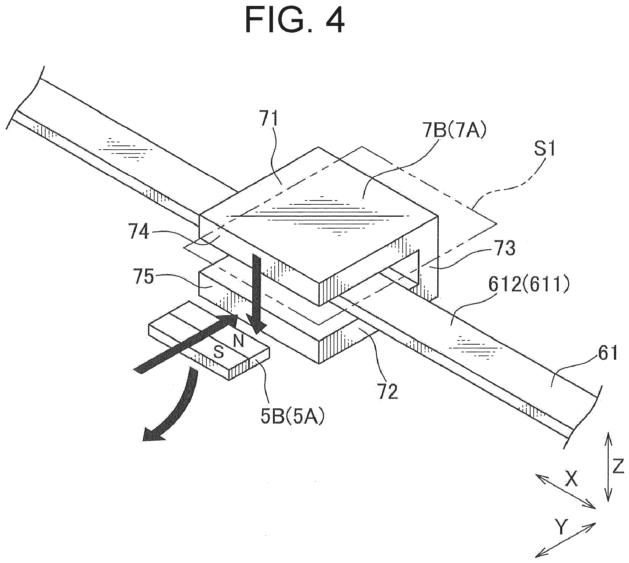

The magnetic elements 5A, 5B are permanent magnets formed in a plate shape and are respectively arranged at central parts 31, 32 in the X direction on a lower face (i.e., a face opposite to the surface 21) of the rotary frame 3. That is, the two magnetic elements 5A, 5B are arranged on both sides in the Y direction of the rotary frame 3. The elliptical rotary frame 3 is closest to the base part 4 at the central parts 31, 32, and thus the central parts 31, 32 are closest parts. As shown in FIG. 4, the magnetic elements 5A, 5B have magnetic poles (N pole and S pole) arranged in the Y direction.

The coil part 6 is formed by a wiring 61 extending along the base part 4. That is, the wiring 61 is wound in a rectangular shape with its longitudinal direction corresponding to the X direction, thereby forming the coil part 6. The number of turns of the wiring 61 wound along the base part 4 is appropriately set according to various conditions such as driving force to be applied to the second driven part, a space on the base part 4 and an allowable current for the wiring 61. In this example, the coil part 6 is provided on the lower face 42 of the base part 4, but it may be provided on the upper face 41, or it may be provided on both of the upper face 41 and the lower face 42. Herein, the upper face 41 of the base part 4 is a face that faces the same side as the surface (reflective face) 21 of the mirror 2.

An appropriate power source is connected to both ends of the wiring 61 to supply electric power as needed. That is, a voltage having a frequency corresponding to the resonance frequency of the mirror 2 is applied to the both ends of the wiring 61 to generate a magnetic field. The wiring 61 includes axially extending parts 611, 612 extending along the X direction.

The yoke parts 7A, 7B are made of a ferromagnetic metal such as iron, and are arranged so as to surround the axially extending parts 611, 612, respectively, so as to correspond to the magnetic elements 5A, 5B, respectively. That is, the yoke parts 7A, 7B are arranged so as to face the magnetic elements 5A, 5B, respectively, in the Y direction (i.e., so as to overlap with them when viewed from the Y direction).

Each of the yoke parts 7A, 7B includes a first extending part 71 extending along the XY plane on the upper side in the Z direction (i.e., the surface 21 side) of the axially extending part 611, 612, a second extending part 72 extending along the XY plane on the lower side in the Z direction of the axially extending part 611, 612, and a connecting part 73 extending along the ZX plane on the outside of the axially extending part 611, 612 (i.e., on the side opposite to the rotary frame 3) and connecting the first extending part 71 and the second extending part 72.

That is, the yoke parts 7A, 7B are formed in an opened annular shape that is opened on the rotary frame 3 side and that surrounds the axially extending parts 611, 612 from both sides of the reference plane S1 and from the side opposite to the rotary frame 3. In this example, the base part 4 is also surrounded by the yoke parts 7A, 7B. Further, an inner end of the first extending part 71 and an inner end of the second extending part 72 correspond to a pair of ends 74, 75 of the yoke parts 7A, 7B. In the Z direction, the reference plane S1 is sandwiched between the pair of ends 74, 75.

The coil part 6 and the yoke parts 7A, 7B as described above function as a driving means configured to rotate the movable part by applying the magnetic field onto the magnetic elements 5A, 5B.

The pedestal 8 is configured such that the base part 4 is fixed thereto to support the base part 4, and an upper face thereof (i.e., a face thereof on the base part 4 side) is provided with a recessed part (accommodating part) for accommodating the coil part 6. That is, the coil part 6 is arranged inside the pedestal 8. A recessed part (accommodating part) capable of accommodating the coil part 6 may be formed on the lower face (i.e., a face on the pedestal 8 side) of the base part 4.

Now, the details of the driving force applied to the mirror 2 and the rotary frame 3 will be described. When a current flows through the coil part 6 and a magnetic field is generated, lines of magnetic force are to pass through the yoke parts 7A, 7B. Thus, the lines of magnetic force are to pass from one side toward the other side of the pair of ends 74, 75 (i.e., along the Z direction). Further, the magnetic poles of the magnetic elements 5A, 5B are arranged in the Y direction.

Due to these magnetic interactions, the rotary frame 3 provided with the magnetic elements 5A, 5B and supported by the outer torsion bars 30 arranged along the X direction is applied with the driving force that rotates the rotary frame 3 with respect to the X direction as the axis direction. The driving force generated at the magnetic element 5A and the driving force generated at the magnetic element 5B have the same direction of rotation.

Since the current flowing through the coil part 6 has a frequency corresponding to the resonance frequency of the mirror 2, the rotary frame 3 does not rotate significantly even when the driving force is applied. It is preferable that the resonance frequency of the mirror 2 and the resonance frequency of the rotary frame 3 are different from each other, and it is more preferable that one of the resonance frequencies is not an integer multiple of the other one of the resonance frequencies.

When the rotation of the rotary frame 3 is transmitted to the mirror 2 via the inner torsion bars 20, the mirror 2 rotates more than the rotary frame 3, since the frequency of the rotation of the rotary frame 3 substantially corresponds with the resonance frequency of the mirror 2. In this manner, the driving force applied to the rotary frame 3 is transmitted to the mirror 2.

According to the above-described configuration, the magnetic elements 5A, 5B are provided on the rotary frame 3, thus the mirror 2 and the ends 74, 75 of the yoke parts 7A, 7B are prevented from interfering with each other, and, by disposing the magnetic elements 5A, 5B close to the ends 74, 75, the entire device can be downsized.

Further, since the magnetic elements 5A, 5B are provided on the rotary frame 3, the mirror 2 and the ends 74, 75 are prevented from interfering with each other even when the driving force is increased and the swing angle of the mirror 2 is increased by disposing the magnetic elements 5A, 5B and the ends 74, 75 of the yoke parts 7A, 7B close to each other. In this instance, by generating, at the ends 74, 75, the magnetic field having a frequency corresponding to the resonance frequency of the mirror 2, the swing angle of the mirror 2 can be increased while the swing angle of the rotary frame 3 can be made smaller than the swing angle of the mirror 2, thereby preventing the interference between the mirror 2 and the ends 74, 75. In this way, the interference between the components can be prevented while obtaining a large driving force, and the swing angle of the mirror 2 can be increased.

Furthermore, the magnetic elements 5A, 5B are arranged at the central parts 31, 32 of the rotary frame 3 that are closest to the base part 4, and this facilitates application of the magnetic field generated at the ends 74, 75 of the yoke parts 7A, 7B onto the magnetic elements 5A, 5B, thus a large driving force can be obtained and the swing angle of the mirror 2 can be increased.

Further, the magnetic elements 5A, 5B are arranged at the central parts 31, 32 in the X direction of the rotary frame 3, thereby preventing a movement such as twisting with respect to the rotation around the outer torsion bars 30 as the axis direction during the driving of the rotary frame 3.

Further, the two magnetic elements 5A, 5B are arranged on both sides in the Y direction of the rotary frame 3, thus the rotary frame 3 can be driven from both sides in the Y direction.

Further, the yoke parts 7A, 7B are formed in an opened annular shape that is opened on the rotary frame 3 side and that surrounds the axially extending parts 611, 612 of the coil part 6, thus the lines of magnetic force concentrate at the yoke parts 7A, 7B when a current flows through the axially extending parts 611, 612, so this facilitates application of the magnetic field generated at the ends 74, 75 of the yoke parts 7A, 7B onto the magnetic elements 5A, 5B on the rotary frame 3 side where they are opened.

Further, since the inner torsion bars 20 and the outer torsion bars 30 are arranged coaxially, the driving force applied to the rotary frame 3 can be easily transmitted to the mirror 2.

Further, since the coil part 6 is arranged on the pedestal 8, the entire driving device 1A can be downsized.

Further, since the coil part 6 is constituted of the wiring 61 extending along the base part 4, the entire driving device 1A can be downsized as compared with the configuration in which the coil part is arranged side by side with respect to the base part.

### SECOND EXAMPLE

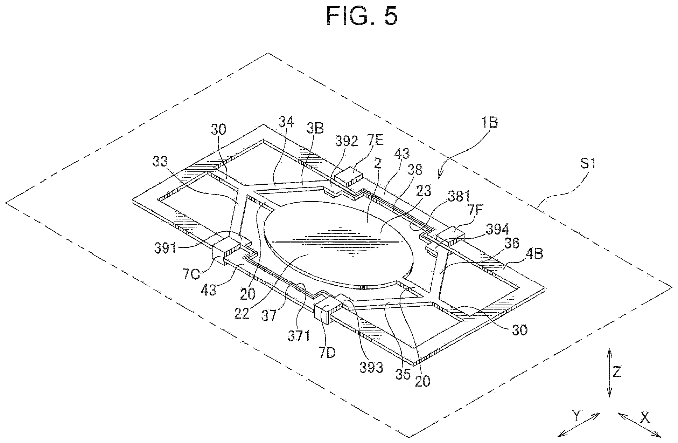

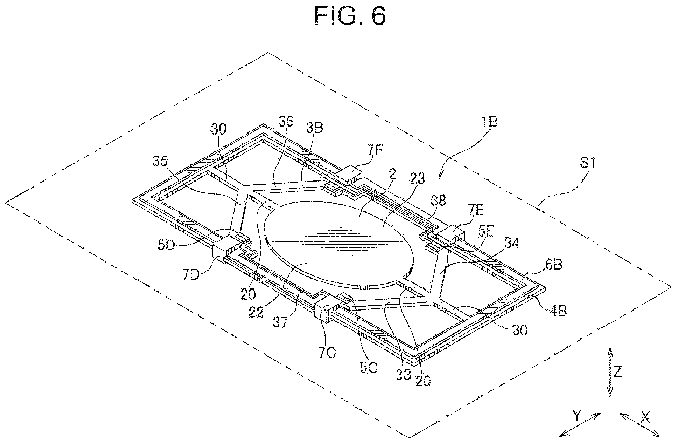

As shown in FIGS. 5 and 6, a driving device 1B of this example is an optical deflector including a mirror 2 as a first driven part, a rotary frame 3B as a second driven part, a base part 4B, four magnetic elements 5C-5F, a coil part 6B, four yoke parts 7C-7F, a pedestal, an inner torsion bar 20 as a first shaft part, and an outer torsion bar 30 as a second shaft part. Although the pedestal is not shown in FIGS. 5 and 6, the pedestal of the driving device 1B is the same as the pedestal 8 of the driving device 1A of the first example. In this example also, the X direction, the Y direction and the Z direction are the same as those in the first example.

The rotary frame 3B is formed in a hexagonal annular shape having vertices at both ends in the X direction when viewed from the Z direction, and it extends along the XY plane so as to surround the mirror 2. That is, the rotary frame 3B includes four inclined parts 33-36 extending so as to approach the mirror 2 in the X direction and approach the base part 4B in the Y direction, and it also includes parallel parts 37, 38 extending along the X direction.

An intersection of the inclined part 33 and the inclined part 34 corresponds to one end of the rotary frame 3B in the X direction, where the inner torsion bar 20 is connected to the inner side and the outer torsion bar 30 is connected to the outer side. Further, an intersection of the inclined part 35 and the inclined part 36 corresponds to the other end of the rotary frame 3B in the X direction, where the inner torsion bar 20 is connected to the inner side and the outer torsion bar 30 is connected to the outer side.

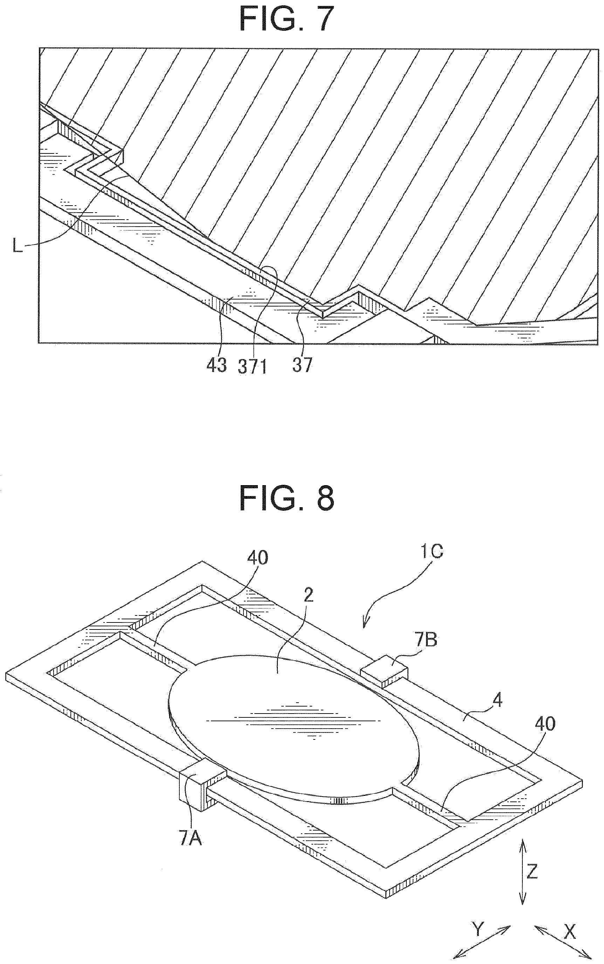

The parallel part 37 extends so as to connect the inclined part 33 and the inclined part 35, and the parallel part 38 extends so as to connect the inclined part 34 and the inclined part 36. As shown in FIG. 7, the parallel parts 37, 38 include convex parts 371, 381 arranged toward outside in the Y direction (i.e., side opposite to the mirror 2) so as to recede from the respective closest parts 22, 23 of the mirror 2 located closest to the base part 4B.

Further, the widths (dimensions in the Y direction) of the parallel parts 37, 38 are smaller than the widths of the inclined parts 33-36. That is, the width of the rotary frame 3B at the positions corresponding to the closest parts 22, 23 is smaller than the width at rest of the rotary frame 3B.

The base part 4B includes convex parts 43 corresponding to the convex parts 371, 381, that is, the base part 4B is formed so as to recede from the mirror 2 at the convex parts 43. Further, the coil part 6B is arranged along the base part 4B and similarly includes convex parts.

The magnetic elements 5C-5F are arranged at intersections 391-394 of the inclined parts 33-36 and the parallel parts 37, 38, respectively. The intersections 391-394 are displaced in the X direction with respect to the closest parts 22, 23.

The yoke parts 7C-7F correspond to the magnetic elements 5C-5F, respectively, and are arranged so as to avoid the convex parts 43 of the base part 4B. The shape of the yoke parts 7C-7F is the same as the shape of the yoke parts 7A, 7B in the first example.

According to the above-described configuration, as in the case of the first example, the magnetic elements 5C-5F are provided on the rotary frame 3B, thus the entire device can be downsized and the swing angle of the mirror 2 can be increased. In addition, the coil part 6B is constituted of the wiring 61 extending along the base part 4B, thus the entire driving device 1B can be downsized.

Further, the magnetic elements 5C-5F are arranged so as to be displaced in the X direction with respect to the closest parts 22, 23, thus the mirror 2 can be easily disposed close to the base part 4B at the closest parts 22, 23, and the surface area of the mirror 2 can be increased.

Further, the rotary frame 3B includes the convex parts 371, 381 that are facing opposite to the mirror 2, and the widths of the parallel parts 37, 38 are smaller than the widths of the inclined parts 33-36, thus it is possible to prevent the light L directed toward the mirror 2 from being blocked by the rotary frame 3B at the closest parts 22, 23.

### THIRD EXAMPLE

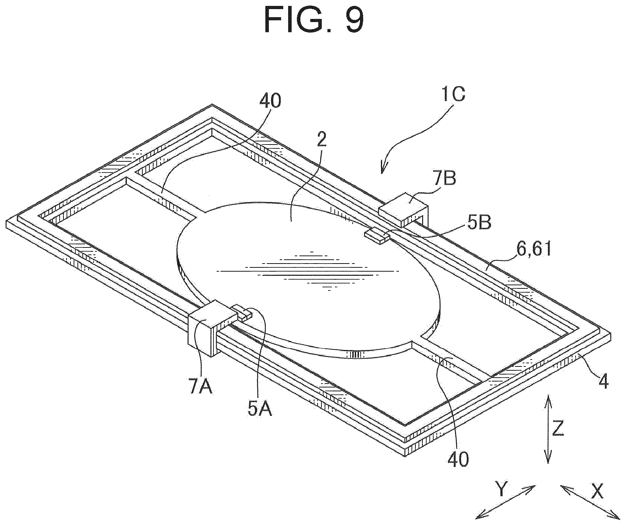

As shown in FIGS. 8 and 9, a driving device 1C of this example is an optical deflector including a mirror 2, a base part 4, two magnetic elements 5A, 5B, a coil part 6, two yoke parts 7A, 7B, a pedestal and a torsion bar 40. That is, the driving device 1C corresponds to the driving device 1A of the first example except the rotary frame 3 and the inner torsion bars 20 are omitted and the mirror 2 is rotatably supported by the base part 4 via the torsion bars 40. In addition, the magnetic elements 5A, 5B are arranged on the closest parts 22, 23 on the lower face of the mirror 2. Although the pedestal is not shown in FIGS. 8 and 9, the pedestal of the driving device 1C is the same as the pedestal 8 of the driving device 1A of the first example. In this example also, the X direction, the Y direction and the Z direction are the same as those in the first example.

According to the above-described configuration, as in the case of the first example, the coil part 6 is constituted of the wiring 61 extending along the base part 4, thus the entire driving device 1C can be downsized. Further, the magnetic elements 5A, 5B are arranged at the closest parts 22, 23 of the mirror 2, and this facilitates application of the magnetic field generated at the ends of the yoke parts 7A, 7B onto the magnetic elements 5A, 5B, thereby obtaining a large driving force and increasing the swing angle of the driven part.

The present invention is not limited to the examples described above, but includes other configurations and the like that can achieve the object of the present invention, and the following modifications and the like are also included in the present invention.

For example, in the first to third examples, the mirror 2 has an elliptical plate shape, but the mirror as the first driven part may have other shapes such as a circular plate shape or a polygonal plate shape, or may have any shape appropriate for its application.

Further, in the first to third examples described above, the yoke parts 7A-7F have the opened annular shape that surrounds the axially extending part of the coil part and that is opened on the rotary frame side; however, the shape and the arrangement of the yoke parts are not limited to these as long as the yoke parts are configured so as to allow the magnetic flux to pass therethrough upon generation of the magnetic field by the coil part.

Further, in the first to third examples described above, the magnetic elements are arranged on both sides in the Y direction with respect to the mirror 2; however, the magnetic element may be arranged only on one side in the Y direction with respect to the mirror 2. In this case, the yoke may also be arranged only on one side in the Y direction with respect to the mirror 2.

Further, in the first example and the second example described above, the inner torsion bars 20 and the outer torsion bars 30 are arranged coaxially; however, the extending direction of the inner torsion bars 20 may intersect the extending direction of the outer torsion bars 30. That is, the torsion bars may have other configurations as long as they allow to transmit the rotation of the rotary frame 3, 3B to the mirror 2 when the rotary frame 3, 3B is rotated.

Further, in the third example, the magnetic elements 5A, 5B are arranged at the closest parts 22, 23 of the mirror 2; however, the magnetic elements 5A, 5B may be arranged at positions displaced in the X direction with respect to the closest parts 22, 23 of the mirror 2.

Although the preferred configurations and methods and such for carrying out the present invention have been described above, the present invention is not limited to these. That is, although the present invention is mainly illustrated and described with respect to specific examples, those skilled in the art can make modifications to the above-described examples regarding the shape, materials, quantities and other detailed configurations without departing from the scope of the technical idea and purpose of the present invention. Therefore, since the description limiting the shape, material, etc. disclosed above is merely an example for facilitating the understanding of the present invention and does not limit the present invention, the description of name of a member without a part or all of the limitation of the shape, materials, etc., is within the present invention.

### REFERENCE SIGNS LIST

- 1A-1C: driving device
- 2: mirror (first driven part)
- 22, 23: closest part
- 3, 3B: rotary frame (second driven part)
- 31, 32: central part (closest part)
- 4, 4B: base part
- 5A-5F: magnetic element
- 6, 6B: coil part
- 61: wiring
- 611, 612: axially extending part
- 7A-7F: yoke part
- 8: pedestal
- 20: inner torsion bar (first shaft part)
- 30: outer torsion bar (second shaft part)
- 40: torsion bar (shaft part)
- S1: reference plane

## Claims

1. A driving device comprising:
a first driven part;
a second driven part that rotatably supports the first driven part via a first shaft part;
a base part that rotatably supports the second driven part via a second shaft part;
a magnetic element provided on the second driven part; and
a yoke part including a pair of ends and configured to rotate the first driven part via the second driven part by applying a magnetic field generated at the ends to the magnetic element, wherein
the yoke part is arranged to sandwich, between the pair of ends, a reference plane on which the base part extends.

2. The driving device as claimed in claim 1, wherein a swing angle of rotation of the first driven part is greater than a swing angle of rotation of the second driven part.

3. The driving device as claimed in claim 1 or 2, wherein the magnetic element is disposed at a closest part of the second driven part with respect to the base part.

4. The driving device as claimed in one of claims 1-3, wherein the magnetic element is disposed at a central part, in an axis direction of the second shaft part, of the second driven part.

5. The driving device as claimed in claim 1 or 2, wherein
the first driven part is formed in a circular plate shape or an elliptical plate shape, and
the magnetic element is disposed at a position on the second driven part that is displaced in an axis direction of the first shaft part with respect to a closest part where the base part is closest to the first driven part.

6. The driving device as claimed in claim 5, wherein, at a position corresponding to the closest part, the second driven part has a width in a facing direction in which the base part and the first driven part face each other that is smaller than that of rest of the second driven part.

7. The driving device as claimed in one of claims 1-6, wherein the magnetic elements are arranged on both sides of the second driven part in a direction intersecting an axis direction of the second shaft part.

8. The driving device as claimed in one of claims 1-7, further comprising a coil part, wherein
a wiring part forming the coil part includes an axially extending part that extends along the base part and extends in an axis direction of the second shaft part, and
the yoke part is formed in an opened annular shape that surrounds the axially extending part from both sides of the reference plane and from a side opposite to the second driven part and that is opened on the second driven part side.

9. The driving device as claimed in one of claims 1-8, wherein the first shaft part and the second shaft part are arranged coaxially.

10. The driving device as claimed in one of claims 1-9, further comprising:
a coil part; and
a pedestal which is made of a non-magnetic material and to which the base part is joined, wherein
the coil part is disposed on the pedestal or in the pedestal.

11. A driving device comprising:
a movable part;
a base part that rotatably supports the movable part via a shaft part;
a magnetic element provided on the movable part; and
a driving section that includes a coil part and that rotates the movable part by applying, to the magnetic element, a magnetic field generated by the coil part, wherein
the coil part is formed by a wiring extending along the base part.
